Europäisches Patentamt

(19) European Patent Office

Office européen des brevets

(11) Publication number : **0 373 004 B1**

## (12) EUROPEAN PATENT SPECIFICATION

(45) Date of publication of patent specification :
28.10.92 Bulletin 92/44

(51) Int. Cl.⁵ : **H05K 13/02, H01L 21/00**

(21) Application number : **89312910.6**

(22) Date of filing : **11.12.89**

(54) **A pellet accommodating and aligning jig.**

(30) Priority : **09.12.88 JP 312563/88**

(43) Date of publication of application :
**13.06.90 Bulletin 90/24**

(45) Publication of the grant of the patent :
**28.10.92 Bulletin 92/44**

(84) Designated Contracting States :
**DE FR GB NL**

(56) References cited :
**FR-A- 2 150 925**
**IBM TECHNICAL DISCLOSURE BULLETIN.**
**vol. 19, no. 11, 11 April 1977, NEW YORK US**
**pages 4169 - 4170;** "automatic pin loader"

(73) Proprietor : **ROHM CO., LTD.**
**21, Saiin Mizosaki-cho Ukyo-ku**
**Kyoto 615 (JP)**

(72) Inventor : **Kurita, Yoshio c/o Rohm Co., Ltd.**
**21, Saiin Mizosaki-cho Ukyo-ku**
**Kyoto 615 (JP)**

(74) Representative : **Bayliss, Geoffrey Cyril et al**
**BOULT, WADE & TENNANT 27 Furnival Street**
**London EC4A 1PQ (GB)**

## Description

The present invention relates to a pellet accommodating and aligning jig which comprises an upper portion having an upper face, a plurality of pellet accommodating recesses in the upper face, each recess having a bottom face, a lower portion having a lower face, and a first through-bore extending from the bottom face of each of the pellet accommodating recesses to the lower face, the upper end of the first through-bore being arranged to be a suction inlet and the lower end being arranged to be a suction outlet.

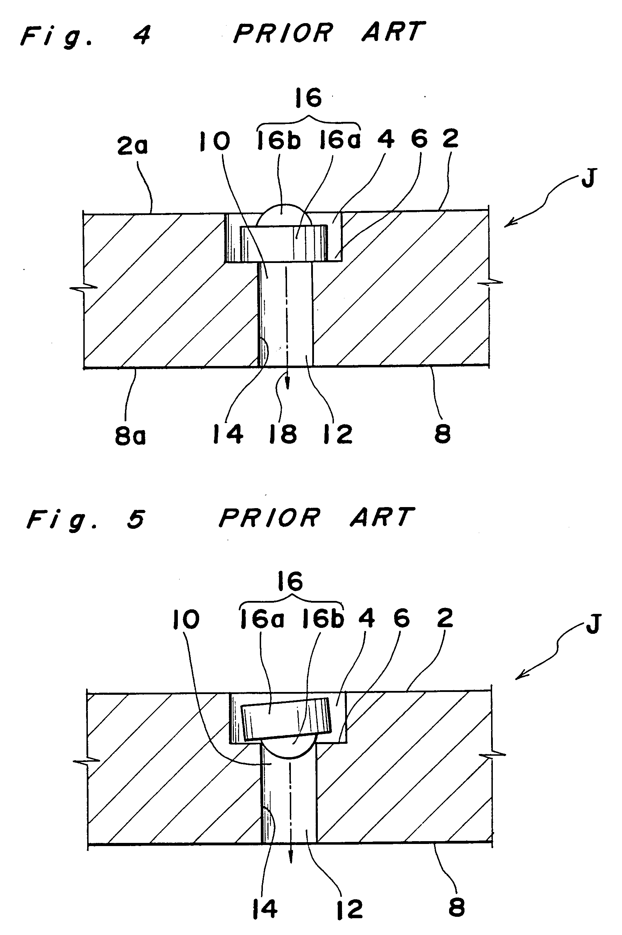

Figures 4 and 5 of the accompanying drawings show a conventional pellet accommodating and aligning jig J of this type which includes an upper portion 2 having an upper face 2a formed with a plurality of pellet accommodating recesses 4, and a lower portion 8 with a lower face 8a. First through-bores 14 extend between a bottom face 6 of each of the pellet accommodating recesses 4 and the lower face 8a of the lower portion 8. The upper end of the through-bore 14 is arranged as a suction inlet 10 and the lower end is arranged as a suction outlet 12. Respective pellets 16 placed on the bottom faces 6 of the corresponding pellet accommodating recesses 4 are arranged to be held against the bottom faces 6 through suction from the inlet 10 towards the outlet 12 in a direction indicated by the arrow 18.

In the known pellet accommodating and aligning jig J as described above, in the case where, for example, pellets of diodes or the like each constituted by a main body 16a and a bump portion 16b are to be accommodated and aligned within the recesses 4 as the pellets 16, and such pellets are required to be in a correct attitude in which the main body 16a thereof faces the bottom face 6 as shown in Figure 4, it has been so arranged to direct the main body 16a of each pellet 16 towards the bottom face 6, for example, by vibrating the pellet accommodating and aligning jig J during the suction, so that the bump portion 16b thereof may not confront the bottom face 6 of the recess 4.

However, in the pellet 16 as referred to above, the bump portion 16b thereof happens to be so constructed as to close the first through-bore 14 as shown in Figure 5 and if suction is effected in the state where the bump portion 16b is directed to the bottom face 6 as in Figure 5, the pellet 16 is held against the bottom face 6 in the above posture. Thus, the pellets 16 are undesirably arranged in the state where they are misaligned within the pellet accommodating recesses 4.

Accordingly, an object of the present invention is to provide a pellet accommodating and aligning jig which is capable of correctly accommodating and aligning pellets within pellet accommodating recesses of the jig, while suction is being effected.

Another object of the present invention is to provide a pellet accommodating and aligning jig of the above described type, which is simple in construction and stable in function, and can be readily manufactured at low cost.

The pellet accommodating and aligning jig is characterised in that a micromesh member is disposed at the bottom of the pellet accommodating recesses, the micromesh member having a plurality of second through-bores each having a diameter smaller than that of the first through-bore.

Due to the fact that the diameter of the second through-bores formed in the micromesh member provided at the bottom of the pellet accommodating recesses is smaller than that of the first through-bores, when the suction is effected through the first through-bore while the jig is being vibrated, even if one or more of the second through-bores are closed by the bump portion or the like of the pellet directed towards the bottom face of the recess, the remaining ones of the second through-bores are still in communication with the first through-bore and, therefore, the pellet is not held against the bottom face of the pellet accommodating recess. Accordingly, if the jig is continuously subjected to vibration, the pellets are eventually correctly aligned in the state where the main body sides thereof confront the bottom faces of the pellet accommodating recesses.

In the accompanying drawings:

Figure 1 is a fragmentary side sectional view of a pellet accommodating and aligning jig;

Figures 2 and 3 are views similar to Figure 1 showing a portion thereof on an enlarged scale, and

Figures 4 and 5 are views similar to Figures 2 and 3 of a conventional pellet accommodating and aligning jig (already referred to).

Like parts are designated by like reference numerals throughout the accompanying drawings.

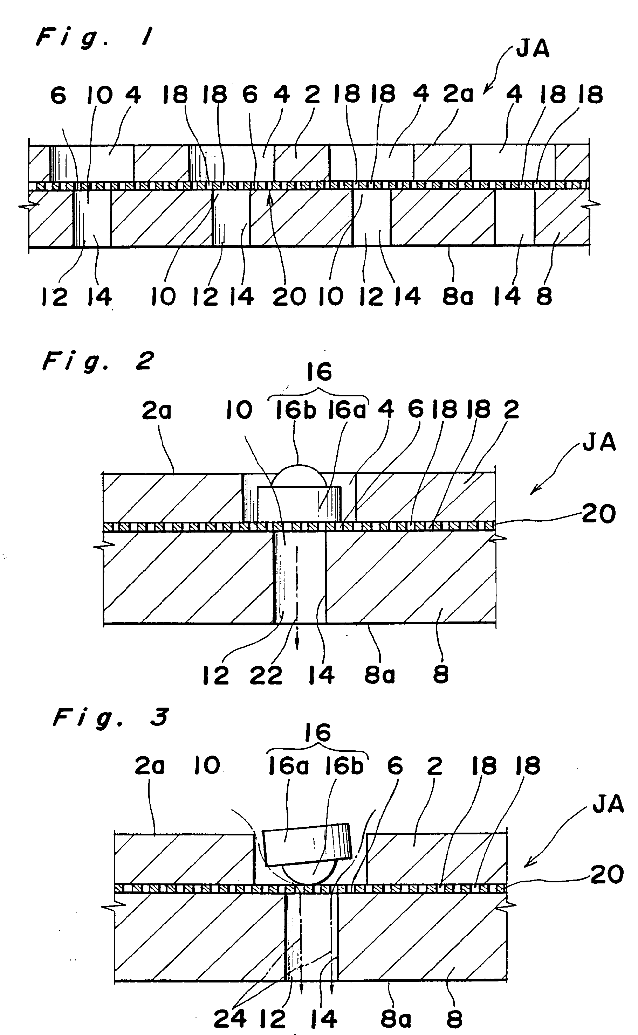

Referring now to the drawings, there is shown in Figures 1 to 3, a pellet accommodating and aligning jig JA, which includes an upper portion 2 having a upper face 2a, a plurality of pellet accommodating recesses 4 in the upper face 2a, a lower portion 8 having a lower face 8a, and a first through-bore 14 extending between a bottom face 6 of each of the pellet accommodating recesses 4 and the lower face 8a. The upper end of the first through-bore 14 is arranged to be a suction inlet 10 and the lower end is arranged to be a suction outlet 12. Pellets 16 placed on the bottom faces 6 of the pellet accommodating recesses 4 are held against the bottom faces 6 through suction from the inlets 10 of the first through-bores 14 towards the outlets 12.

The construction of the pellet accommodating and aligning jig JA of Figures 1 to 3 as described so far is generally similar to that of the conventional pellet accommodating and aligning jig J described earlier with reference to Figures 4 and 5.

However, the pellet accommodating and aligning jig JA of Figures 1 to 3 is further provided with a micromesh member 20 which is disposed at the bottom of the pellet accommodating recesses 4 and is formed with a plurality of second through-bores 18 each having a diameter smaller than that of the first through-bore 14.

Referring particularly to Figures 2 and 3, the operation of the pellet accommodating and aligning jig JA as described so far will be explained hereinafter.

In the first place, when the main body portion 16a of the pellet 16 confronts the bottom face 6 of the pellet accommodating recess 4 through vibration of the pellet accommodating and aligning jig JA as shown in Figure 2, the main body portion 16a closes the first through-bore 14 by way of the micromesh member 20 and so the pellet 16 is attracted and held within the recess 4 upon evacuation of the interior of the first through-bore 14 in a direction indicated by an arrow 22.

However, in the case where the bump portion 16b of the pellet 16 faces the bottom face 6 of the recess 4, by causing the jig JA to vibrate, even when some of the second through-bores 18 are closed by the bump portion 16b of the pellet 16, remaining ones of the second through-bores 18, and also the first through-bore 14, are not closed by the bump portion 16b. Accordingly, even if the interior of the first through-bore 14 is subjected to suction, a vacuum state is not established, since the recess 4 and the first through-bore 14 are still in communication with each other through the second through-bores 18 of the micromesh member 20. Consequently, since the pellet 16 is not attracted onto the bottom face 6 of the recess 4, it is finally inverted from the state in Figure 3 to the state of Figure 2 upon vibration of the pellet accommodating and aligning jig JA, and thus, all pellets 16 are eventually aligned in the correct state within the recess 4 as desired.

## Claims

1. A pellet accommodating and aligning jig which comprises an upper portion (2) having an upper face (2a), a plurality of pellet accommodating recesses (4) in the upper face (2a), each recess (4) having a bottom face (6), a lower portion (8) having a lower face (8a), and a first through-bore (14) extending from the bottom face (6) of each of the pellet accommodating recesses (4) to the lower face (8a), the upper end of the first through-bore (14) being arranged to be a suction inlet (10) and the lower end being arranged to be a suction outlet (12), characterised in that a micromesh member (20) is disposed at the bottom of the pellet accommodating recesses (4), the micromesh member (20) having a plurality of second through-bores (18) each having a diameter smaller than that of the first through-bore (14).

## Patentansprüche

1. Rahmen zum Aufnehmen und Ausrichten von Pellets mit einem oberen Abschnitt (2) mit einer Oberseite (2a), mehreren in der Oberseite (2a) angeordneten Pelletaufnahmevertiefungen (4), wobei jede Vertiefung (4) eine Bodenfläche (6) aufweist, einem unteren Abschnitt (8) mit einer Unterseite (8a) und einer ersten Durchgangsbohrung (14), die sich von der Bodenfläche (6) jeder Pelletaufnahmevertiefung (4) zur Unterseite (8a) erstreckt, wobei das obere Ende der ersten Durchgangsbohrung (14) als Saugeinlaß (10) und das untere Ende als Saugauslaß (12) angeordnet ist,
   **dadurch gekennzeichnet, daß**
   ein Mikromaschenbauteil (20) auf dem Boden der Pelletaufnahmevertiefung (4) angeordnet ist, wobei das Mikromaschenbauteil (20) mehrere zweite Durchgangsbohrungen (18) aufweist, deren Durchmesser kleiner ist als derjenige der ersten Durchgangsbohrung (14).

## Revendications

1. Gabarit de réception et d'alignement de pastille qui comprend une partie supérieure (2) qui comporte une face supérieure (2a), une pluralité d'évidements de réception de pastille (4) ménagés dans la face supérieure (2a), chaque évidement (4) comportant une face de fond (6), une partie inférieure (8) qui comporte une face inférieure (8a) et un premier trou de passage (14) qui s'étend depuis la face de fond (6) de chacun des évidements de réception de pastille (4) jusqu'à la face inférieure (8a), l'extrémité supérieure du premier trou de passage (14) étant agencée de manière à constituer une entrée d'aspiration (10) et l'extrémité inférieure étant agencée de manière à constituer une sortie d'aspiration (12), caractérisé en ce qu'un élément à micromailles (20) est disposé au niveau du fond des évidements de réception de pastille (4), l'élément à micromailles (20) comportant une pluralité de seconds trous de passage (18) dont chacun présente un diamètre inférieur à celui du premier trou de passage (14).

EP 0 373 004 B1

Fig. 1

JA

6 10 4 18 18 6 4 2 18 18 4 2a 4 18 18

12 14 10 12 14 20 10 12 14 8a 14 8

Fig. 2

16

2a 10 16b 16a 4 6 18 18 2

JA

20

12 22 14 8a 8

Fig. 3

16

2a 10 16a 16b 6 2 18 18

JA

20

24 12 14 8a 8

4

## Fig. 4 PRIOR ART

## Fig. 5 PRIOR ART